# FASCICULE DE BREVET EUROPEEN

(11) **EP 1 813 952 B1**
(45) Date de publication et mention de la délivrance du brevet: **21.07.2010**
(21) Numéro de dépôt: 07290101.0
(22) Date de dépôt: 25.01.2007
(51) Int. Cl.: G01R 31/3185

(54) **Test de scan**
Scantest
Scan Test

(30) Priorité: 27.01.2006 FR 0600787
(43) Date de publication de la demande: 01.08.2007
(73) Titulaire: STMICROELECTRONICS SA, 92120 Montrouge (FR)
(72) Inventeur: Armagnat, Paul, 38170 Seyssinet (FR)
(74) Mandataire: Verdure, Stéphane

(56) Documents cités:
- US-A- 5 623 500

## Description

L'invention se rapporte au domaine du test de circuits électroniques, en particulier des circuits intégrés électroniques numériques.

Un circuit électronique numérique est habituellement fabriqué à partir de ce qu'on appelle une description RTL (de l'anglais « Register Transfer Level ») décrivant les opérations du circuit dans un langage de programmation approprié, par exemple le langage C, Verilog ou VHDL (de l'anglais « Very High Speed Integrated Circuit Hardware Description Language »). Une description RTL peut habituellement être validée à l'aide d'outils logiciels de simulation.

Une description au niveau logique (appelée « netlist » en anglais), décrivant un ensemble de portes logiques (correspondant à des assemblages de transistors) et de connexions, peut être synthétisée à partir de la description RTL. Le fonctionnement d'une netlist peut être validé grâce à des tests fonctionnels.

Des étapes de placement et routage conduisent à un dessin des masques (appelé « layout » en anglais) à partir de la description au niveau logique. Ensuite, ce que l'on appelle un test LVS (de l'anglais « Layout versus Schematic ») peut être exécuté afin de vérifier que le layout correspond bien à la description logique.

Puis le circuit est fabriqué à partir du layout.

Le circuit fabriqué doit enfin être testé afin de vérifier qu'aucune porte logique n'est « collée » à une valeur fixe (« stuck at 0 or stuck at 1 » en anglais), en raison de par exemple un court-circuit. Pour tester ainsi le circuit fabriqué, il est connu de pratiquer ce que l'on appelle un test de scan. Les tests de scan utilisent le principe selon lequel tout circuit numérique est constitué d'une partie combinatoire relativement aisée à tester et d'une partie séquentielle se limitant à des bascules de type D. Les bascules de type D peuvent être connectées entre elles grâce à des multiplexeurs pour permettre de contrôler aisément les signaux envoyés ou reçus de la partie combinatoire.

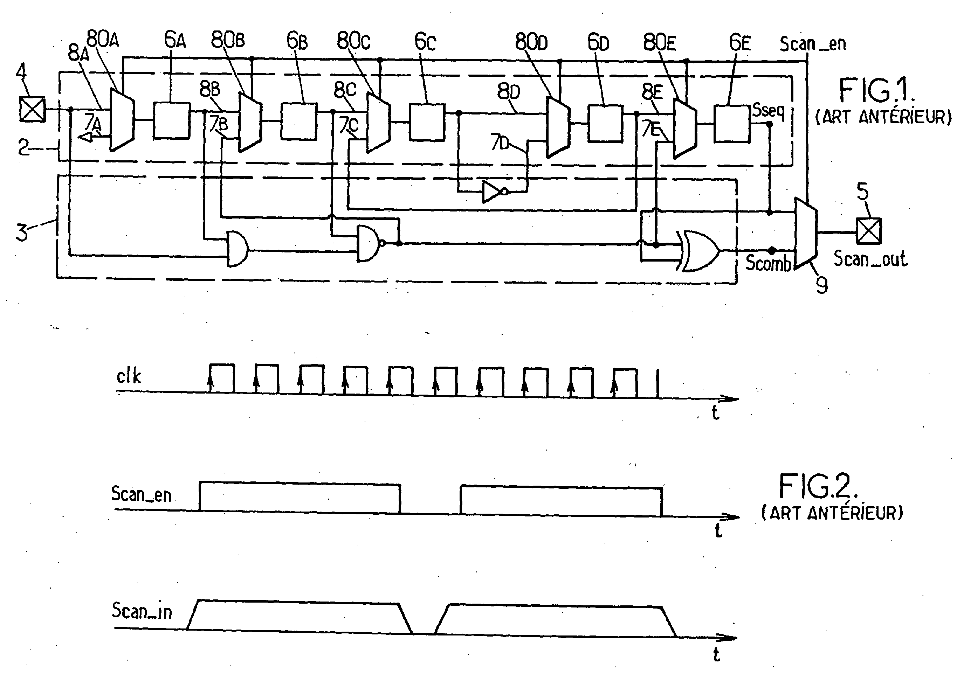

La figure 1 montre un exemple de partie numérique d'un circuit électronique relativement simple apte à être testée par un test de scan. La partie numérique 1 comprend une partie séquentielle 2 et une partie combinatoire 3. La partie séquentielle 2 comprend des bascules 6_{A}, 6_{B}, 6_{C},..., de type D associées chacune à un multiplexeur 80_{A}, 80_{B}, 80_{C},..., et regroupées en une chaîne 2. Chacune des bascules 6_{A}, 6_{B}, 6_{C},..., comprend une entrée de données respectivement 7_{A}, 7_{B}, 7_{C},..., une entrée de scan respectivement 8_{A}, 8_{B}, 8_{C},..., une sortie respectivement 8_{B}, 8_{C}, 8_{D},..., une entrée d'horloge non représentée et une entrée d'autorisation contrôlée par un signal d'autorisation scan_en. Lorsque le signal d'autorisation est à un niveau logique '1', l'état logique des entrées de scan 8_{A}, 8_{B}, 8_{C},..., est recopié sur les sorties correspondantes 8_{B}, 8_{C}, 8_{D},..., à chaque front montant d'horloge. En revanche, lorsque le signal d'autorisation est à un état logique '0', l'état logique des entrées de données 7_{A}, 7_{B}, 7_{C},..., est recopié sur les sorties correspondantes 8_{B}, 8_{C}, 8_{D},..., à chaque front montant d'horloge.

Le signal d'autorisation scan_en commande également un commutateur 9. Lorsque le signal scan_en est à un état logique '0', le signal scan_out à la sortie 5 du circuit électronique prend la valeur du signal S_{comb} à la sortie de la partie combinatoire 3, dite sortie fonctionnelle. Lorsque le signal scan_en est à un état logique '1', le signal scan_out à la sortie 5 prend la valeur du signal S_{seq} à la sortie de la partie séquentielle 2, dite sortie de scan.

La figure 2 montre des chronogrammes illustrant le fonctionnement d'un test de scan de la partie numérique représentée à la figure 1.

Dans un premier temps, le signal scan_en prend une valeur non nulle pendant par exemple cinq cycles d'horloge, permettant ainsi des décalages au sein de la chaîne 2. La chaîne 2 comprenant cinq bascules, cinq cycles d'horloge sont donc nécessaires pour charger la chaîne avec des nouvelles valeurs d'entrée.

Après ces cinq cycles, le signal scan_en passe à zéro. Les sorties des bascules prennent alors des valeurs imposées par des sorties dites secondaires 7_{B}, 7_{C}, 7_{D}, 7_{E} de la partie combinatoire 3. La valeur du signal S_{comb} est lue à la sortie dite primaire de la partie combinatoire 3, c'est-à-dire la sortie fonctionnelle.

Suivent ensuite cinq nouveaux cycles de décalages au sein de la chaîne, le signal scan_en ayant repris une valeur non nulle. A chaque cycle d'horloge, une valeur du signal S_{seq} est lue à la sortie de la chaîne 2. Dit autrement, les sorties secondaires sont lues une à une durant ces cinq cycles dits cycles de purge. Ces cinq cycles de purge permettent en outre de recharger la chaîne avec de nouvelles valeurs d'entrée.

On appelle vecteur de test chaque séquence de cinq valeurs du signal d'entrée. Des procédés de gestion automatique de programme de test ou ATPG (de l'anglais « Automatic Test Pattern Generator ») permettent de générer des vecteurs de test destinés à être placés à l'entrée scan_in de la chaîne. Les valeurs des signaux des vecteurs de test sont telles que, si le circuit fabriqué est fonctionnellement correct, toutes les connections doivent au moins une fois changer de valeur lors du déroulement du test de scan.

En pratique, pour des circuits numériques plus complexes, la chaîne peut comprendre un nombre de bascules relativement élevé, par exemple de l'ordre du millier ou de la dizaine de milliers. Une telle longueur de chaîne rend la durée de lecture des valeurs des sorties secondaires relativement longue. Le test de scan est donc également relativement long.

Il est connu de disposer plusieurs chaînes relativement courtes plutôt qu'une seule chaîne relativement longue, afin d'éviter des durées de test trop élevées. Un seul signal d'entrée d'autorisation scan_en et un seul signal d'horloge clk peuvent commander toutes les chaînes. En revanche, à chaque chaîne de scan sont associées une entrée scan_in et une sortie scan_out respectives. Le nombre de plots requis pour effectuer le test de scan augmente donc avec le nombre de chaînes. Ceci est un inconvénient.

En effet, la complexité du routage des pistes de la carte comprenant le circuit électronique augmente avec le nombre de plots, ainsi que le risque de congestion. Il peut également être possible de réutiliser des plots déjà câblés, auquel cas un multiplexeur devra être prévu pour chaque plot réutilisable, ce qui risque de diminuer la vitesse de fonctionnement du circuit. En outre, il peut éventuellement être nécessaire d'adapter les cellules de commande (« I/O cells » en anglais) des plots à réutiliser afin que les cellules de commande supportent d'autres types de signaux. La consommation augmente également avec le nombre de plots.

Une optimisation entre le nombre de plots et la durée du test doit donc être effectuée.

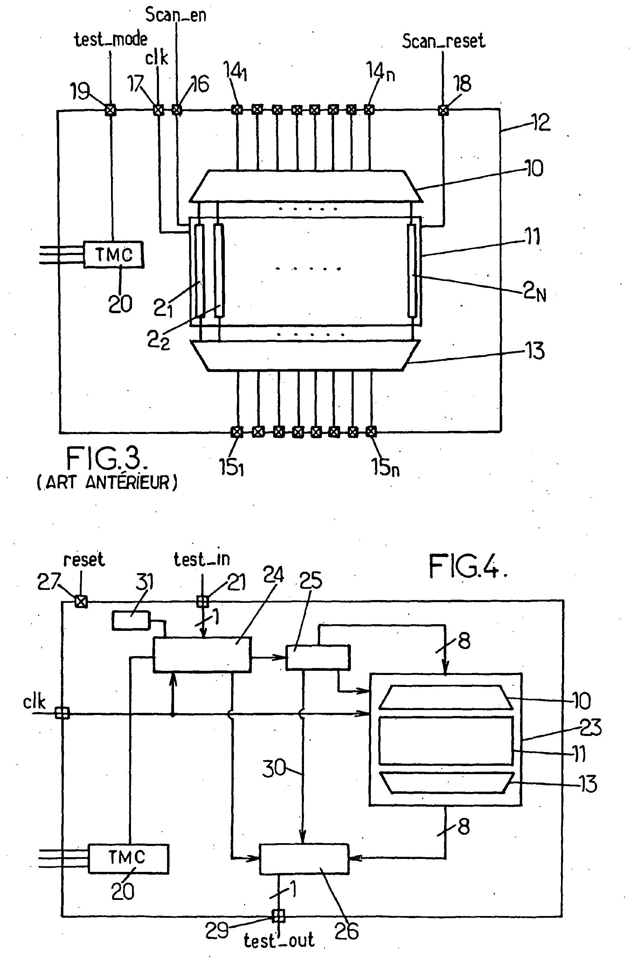

En pratique, les vecteurs générés par les procédés ATPG contiennent relativement peu d'information efficace. Ceci est lié à la structure même de la logique combinatoire. Il est connu de tirer partie de cette inefficacité en utilisant, comme le montre la figure 3, des chaînes de scan 2₁, 2₂,..., 2_{N} relativement courtes. Lesdites chaînes de scan 2₁, 2₂,..., 2_{N} sont chargées par une combinaison logique d'un nombre réduit d'entrées appelées pseudo scan_in aux plots 14₁,..., 14ₙ. Ces combinaisons logiques sont réalisées par un décompresseur 10. Les sorties de ces chaînes courtes sont connectées à une logique de compression 13 dont les sorties appelées pseudo scan_out sont envoyées vers les plots 15₁,..., 15ₙ.

Les procédés ATPG sont capable de générer des vecteurs dits compressés applicables directement aux plots 14₁,..., 14ₙ.. Ces vecteurs ont une longueur moindre que les vecteurs ATPG, de sorte que la durée du test est alors globalement plus faible.

Sur la figure 3, la partie numérique 12 comprend une partie testée 11, des moyens de décompression 10 et des moyens de compression 13. La partie testée 11 comprend un nombre N relativement élevé de chaînes 2₁, 2₂,..., 2_{N} et des parties combinatoires non représentées sur la figure 3.

La partie testée 11 est reliée à un plot 16 d'autorisation, à un plot d'horloge 17 et à un plot 18 de remise à zéro du test de scan.

Par ailleurs, un registre de commande 20 ou TMC (de l'anglais « Test Mode Control ») permet de mémoriser certains paramètres de commande de certaines parties analogiques non représentées, comme par exemple une boucle à verrouillage de phase ou PLL (de l'anglais « Phase-Locked Loop »), ou bien encore un multiplexeur. Ces paramètres commandent par exemple le branchement d'une PLL, ou bien encore la programmation d'un multiplexeur. Le TMC 20 permet ainsi de placer le circuit fabriqué dans un mode désiré, et en particulier dans un mode de test désiré. Le TMC 20 peut par exemple être programmé via une interface standard, par exemple I2C (de l'anglais « Inter Integrated Circuit »). Cette programmation requière généralement au moins un plot numérique 19.

Les moyens de décompression 10 permettent de transformer un nombre n relativement faible de vecteurs d'entrée compressés en N vecteurs d'entrée de chaîne. Les moyens de compression 13 permettent de transformer N vecteurs de sortie de chaîne en n vecteurs de sortie compressés. N peut par exemple être de l'ordre de la centaine, tandis que n peut être de l'ordre de la dizaine. Il est ainsi possible d'obtenir des durées de test relativement courtes, du fait du nombre N de chaînes 2₁, 2₂, ..., 2_{N}, avec un nombre relativement faible 2*n de plots 14₁, 14ₙ, 15₁,...,15ₙ.

Toutefois, une compression n'est efficace qu'à partir d'un certain nombre de vecteurs, typiquement 7 ou 8. Ainsi, pour n=8, le taux de compression est d'environ 50, de sorte que N est d'environ 400. Pour n=5, le taux de compression est d'environ 10 seulement. Or, pour un nombre n de 8, huit plots d'entrée 14₁, 14ₙ et huit plots de sortie 15₁,...,15ₙ dédiés au test de scan sont requis, soit seize plots à ajouter au plot d'autorisation 16, au plot d'horloge 17, au plot de remise à zéro du test de scan 18 et au plot numérique 19.

Ainsi, dans le cas de circuits comprenant un nombre relativement réduit de plots, cette compression ne peut être effectuée de manière efficace, de sorte que la durée du test peut encore être relativement élevée.

La spécification IEEE 1149.1 propose d'utiliser une machine d'états afin de diminuer le nombre de plots dédiés (c'est à dire réservés) au test de scan. La machine d'états est contrôlée par un certain nombre de plots dédiés à la machine d'états : un plot TMS de commande, un plot TDI de données, un plot TCK d'horloge, un plot TRSTN de remise à zéro et un plot TDO de sortie. La machine d'états permet de transmettre les données reçues au plot TDI de données à l'entrée de la chaîne souhaitée en utilisant un protocole prédéfini (voir par exemple US 5 623 500). Toutefois, compte tenu de la complexité du test de scan, cette gestion peut se révéler inopérante, en particulier dans le cas d'une compression.

De manière générale, les tests de scan connus requièrent un certain nombre de plots réservés au test de scan. La présente invention a pour objectif de limiter le nombre de plots ainsi dédiés au test de scan, afin de réduire l'encombrement associé.

Selon un premier aspect, l'invention a pour objet un circuit électronique selon la revendication 1.

La machine d'états peut ainsi passer d'un état à l'autre en fonction du signal reçu sur le plot d'entrée réservé à la machine d'états. L'état dans lequel se trouve la machine d'états permet d'adresser tel ou tel dispositif du groupe de dispositifs pour le transfert des données, ce qui permet de diminuer le nombre de plots nécessaires au fonctionnement de ces dispositifs.

De plus, la machine d'états est adaptée pour utiliser sélectivement l'un parmi plusieurs protocoles de transfert de données : cette souplesse permet de diminuer le nombre de plots réservés à la machine d'états. Par exemple, seul le plot d'entrée peut être réservé à la machine d'états, les autres plots impliqués dans le fonctionnement de la machine d'états étant sollicités uniquement lorsque la machine d'états se trouve dans certains états. Alternativement, un ou plusieurs autres plots, par exemple un plot de sortie, peuvent également être réservé à la machine d'états.

Le circuit électronique, par exemple un circuit intégré, peut ainsi mettre en oeuvre un test de scan avec relativement peu de plots dédiés au test de scan.

Dans un exemple, la pluralité de protocoles que la machine d'états est adaptée pour supporter peut comprendre au moins un protocole dans lequel le signal reçu à un plot d'horloge joue le rôle de signal d'horloge de la machine d'états, et au moins un protocole dans lequel le rôle de signal d'horloge de la machine d'états est assuré par un autre signal. Ainsi, la machine d'états peut décider de solliciter le plot d'horloge seulement si besoin est, de sorte qu'un plot d'horloge réservé à la machine d'état n'est pas forcément nécessaire.

Dans un exemple, la machine d'états est adaptée pour être placée sélectivement dans l'un parmi une pluralité de modes de fonctionnement comprenant un mode de test de scan. La pluralité de protocoles que la machine d'états est adaptée pour supporter peut alors comprendre au moins deux protocoles de fonctionnement distincts correspondant chacun à l'un respectif des modes de fonctionnement de la pluralité de modes de fonctionnement. Ainsi, la machine d'états peut utiliser tel ou tel protocole de fonctionnement selon le mode de fonctionnement. En particulier, lesdits au moins deux protocoles de fonctionnement peuvent être adaptés à leurs modes de fonctionnement respectifs, de façon à éviter des étapes fastidieuses lorsque la machine d'état se trouve dans l'un desdits modes de fonctionnement. Ainsi, la machine d'états peut fonctionner relativement rapidement, contrairement aux machines d'états de l'art antérieur soumises à un protocole figé. En outre, lorsqu'un protocole de fonctionnement est adopté, la machine d'états peut décider d'utiliser ou de ne plus utiliser tel ou tel plot, permettant ainsi de diminuer le nombre de plots réservés à la machine d'états.

La pluralité de modes de fonctionnement peut en particulier comprendre une pluralité de modes de tests différents comprenant le mode de test de scan précité. La pluralité de modes de fonctionnement peut également comprendre des modes permettant de remplir une fonction autre que le test.

La présente invention n'est bien entendu pas limitée à ces exemples de protocoles.

En particulier, le groupe de dispositifs peut aussi comprendre un dispositif de commande pour imposer le mode de fonctionnement dans lequel la machine d'états doit être placée. Ce dispositif est lui-même programmé par la machine d'états. Cette dernière adopte tel ou tel mode de fonctionnement en fonction des valeurs programmées, conférant ainsi une certaine souplesse et une certaine rapidité à la sélection d'un mode de fonctionnement.

Avantageusement, la pluralité de protocoles que la machine d'états est susceptible d'utiliser peut comprendre un protocole de programmation de mode permettant de programmer le dispositif de commande. La machine d'états peut ainsi adopter un protocole de programmation de mode adapté à la programmation du dispositif de commande et donc relativement efficace.

Avantageusement, le dispositif de commande comprend un registre de commande pour mémoriser des paramètres de commande du mode de fonctionnement. Ce registre peut être un registre à décalage, et peut être programmé en série à partir du plot d'entrée. On peut ainsi éviter des plots dédiés ou une interface standard pour programmer le registre de commande.

Dans des modes de réalisation, le groupe de dispositifs comprend un dispositif d'entrée de test de scan pour envoyer vers la partie du circuit électronique à tester des données d'entrée de test, et/ou un dispositif de contrôle pour contrôler le déroulement du test de scan. Le dispositif d'entrée de test et/ou le dispositif de contrôle peuvent être programmés via le plot d'entrée relié à la machine d'états.

Cet exemple n'est pas limitatif : le dispositif de contrôle peut par exemple être programmé directement par un autre plot dédié. De plus, l'invention n'est pas limitée par la séparation contrôle/données au sein du dispositif de test de scan. Le dispositif de test de scan peut en effet être agencé différemment.

Lorsque le groupe de dispositifs comprend un dispositif d'entrée de test de scan, ce dernier peut avantageusement comprendre un registre d'entrée pour recevoir les données d'entrée de test à envoyer vers la partie du circuit électronique à tester. Ainsi, chaque bit du registre d'entrée peut correspondre à une chaîne de bascules. Le registre d'entrée, par exemple un registre à décalage, est d'abord chargé bit par bit à partir du plot d'entrée dédié à la machine d'états, puis chaque bit est envoyé vers la chaîne de bascules correspondante. Il est ainsi possible de fournir des signaux d'entrée à plusieurs chaînes de bascules avec seulement un plot d'entrée dédié à la machine d'états.

Bien entendu, le fait que toutes les données d'entrée proviennent d'un même plot d'entrée limite a priori le débit des données d'entrée. Cependant, le registre à décalage permet de créer artificiellement plusieurs entrées, par exemple une dizaine, à partir d'un seul plot d'entrée. Si les bits mémorisés dans le registre à décalage sont envoyés vers des moyens de décompression, les données d'entrée peuvent être décompressées pour alimenter un nombre relativement élevé de chaînes de bascules, de l'ordre de la centaine, comme illustré sur la figure 3. On peut ainsi bénéficier des effets de la décompression, à savoir des durées de test relativement courtes, avec un seul plot d'entrée ou un très petit nombre de plots d'entrée.

Lorsque le groupe de dispositifs comprend un dispositif de contrôle, ce dernier peut avantageusement comprendre un registre de contrôle destiné à mémoriser des paramètres de contrôle du déroulement du test de scan. Le registre de contrôle peut par exemple permettre de mémoriser un bit d'autorisation dont la valeur détermine si ce sont les sorties secondaires ou la sortie primaire qui sont lues en sortie de chaîne de bascules. Ce bit d'autorisation peut être programmé via le plot dédié à la machine d'états, cette dernière sachant quelle donnée lue au niveau de ce plot correspond au bit d'autorisation.

Avantageusement, le registre d'entrée et le registre de contrôle font partie d'un même registre à décalage, permettant ainsi une programmation en série de ces registres relativement rapide.

Selon un deuxième aspect, l'invention a pour objet un appareil électronique comprenant un circuit électronique selon le premier aspect de l'invention. La présente invention n'est pas limitée par la nature de l'appareil électronique, de sorte qu'elle trouve des applications dans des domaines variés. A titre d'exemple, l'appareil électronique peut par exemple être un lecteur de DVDs (de l'anglais « Digital Versatil Disk ») ou bien encore un appareil de contrôle de direction destiné à être embarqué dans un véhicule automobile.

Selon un troisième aspect, l'invention a pour objet un procédé selon la revendication 14.

Ce procédé peut par exemple être mis en oeuvre à l'aide du circuit électronique selon le premier aspect de l'invention et offre au moins les mêmes avantages.

D'autres particularités et avantages de la présente invention apparaîtront dans la description ci-après.

La figure 1, déjà commentée, montre un exemple de partie numérique d'un circuit électronique apte à être testé par un test de scan, connu de l'art antérieur.

La figure 2, déjà commentée, montre des exemples de chronogrammes illustrant le déroulement d'un test de scan connu de l'art antérieur.

La figure 3, déjà commentée, montre un exemple de partie numérique d'un circuit électronique dont une partie est apte à être testée par un test de scan connu de l'art antérieur.

La figure 4 montre un exemple de partie numérique de circuit électronique selon un mode de réalisation de l'invention.

La figure 5 montre un exemple d'algorithme d'une machine d'états du circuit électronique de la figure 4.

La figure 6 montre des exemples de chronogrammes illustrant un exemple de fonctionnement de la machine d'état du circuit électronique de la figure 4.

La figure 7 montre de façon plus détaillée le premier registre à décalage du circuit électronique de la figure 4.

Dans le mode de réalisation illustré par les figures 4, 5 et 6, un circuit électronique comprend un machine d'états 24 reliée à un plot d'entrée numérique 21 d'une part, et à un groupe de dispositifs 20, 25, 26, 23 d'autre part. Le groupe de dispositifs comprend plusieurs dispositifs de test de scan 25, 26, 23 d'une partie 11 du circuit électronique dite également coeur.

Le groupe de dispositifs comprend également un dispositif de commande 20 pour imposer des modes de fonctionnement et en particulier des modes de test. Dans cet exemple, le dispositif 20 comprend un registre de commande TMC destiné à mémoriser des paramètres de commande du mode de test. Le registre TMC est un registre à décalage. Le registre TMC, dit également TCR (de l'anglais « Test Control Register »), permet par exemple de mémoriser un paramètre de test des mémoires ou BIST (de l'anglais « Built In Self Test ») et un paramètre de test de scan. Si la valeur du paramètre de BIST, respectivement de test de scan, est par exemple de 1, alors le registre TMC impose de procéder à un test de BIST, respectivement à un test de scan.

Le groupe de dispositifs comprend un dispositif à compression 23 comprenant des moyens de décompression 10 et des moyens de compression 13, respectivement en entrée et sortie de la partie testée 11.

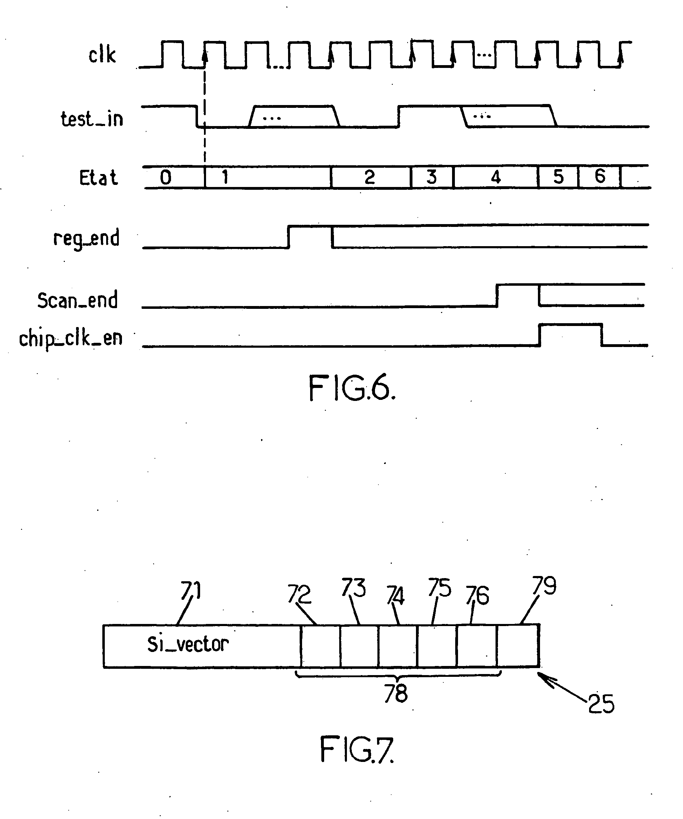

Le groupe de dispositifs peut en outre comprendre un premier registre à décalage 25, comprenant à la fois un registre d'entrée de par exemple huit bits et un registre de contrôle de par exemple cinq bits. Le registre d'entrée permet de recevoir des données d'entrée de test à envoyer vers les moyens de décompression 10. Le registre de contrôle permet de mémoriser des paramètres de contrôle du déroulement du test de scan. Le registre à décalage est décrit de façon détaillée plus loin, en référence à la figure 7.

Le groupe de dispositifs comprend en outre un second registre à décalage 26 comprenant un registre de sortie de par exemple huit bits. Le registre de sortie permet de recevoir les valeurs lues en sortie des moyens de compression 13.

Le premier et le second registres à décalage 25, 26 peuvent être reliés via une connexion 30, à des fins de test du dispositif de test de scan (« bypass » en anglais).

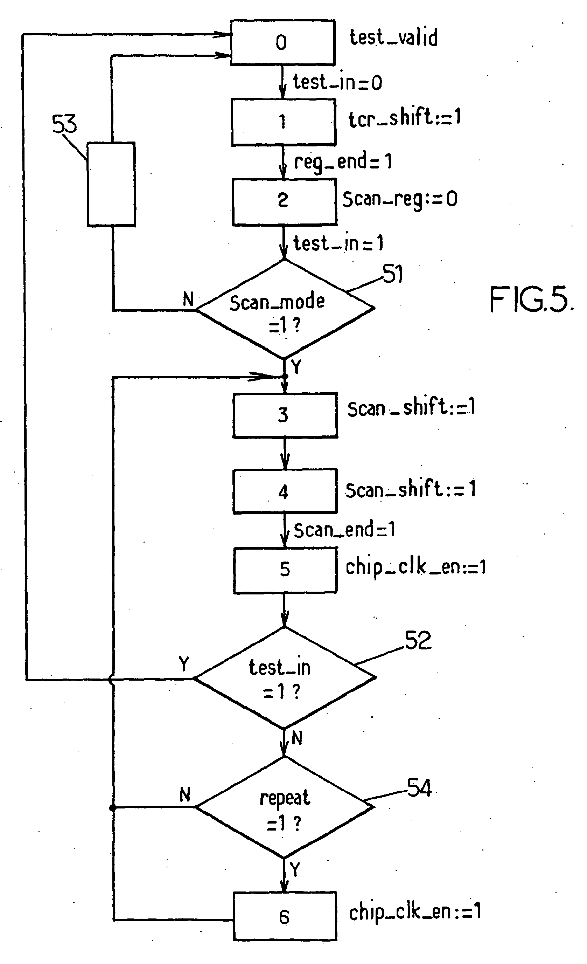

Les figures 5 et 6 sont relatives à l'activité de la machine d'états et seront commentées simultanément. Sur la figure 5, les états de la machine d'états sont représentés par des rectangles orientés horizontalement. Le critère à vérifier pour passer d'un état à l'autre est écrit adjacent à la flèche entre ces deux états. Lorsque la machine d'états se trouve dans un état donné, elle peut agir sur telle ou telle variable : cette variable et la valeur qui lui est affectée sont inscrites de façon adjacente au rectangle correspondant à l'état donné.

Initialement, la machine d'états se trouve dans un état d'attente non représenté. Le groupe de dispositifs comprend un registre d'attente 31 sur la figure 4 permettant de mémoriser une variable d'attente programmée par la machine d'états 24. Dans l'état d'attente, le registre TMC, les premier et second registres à décalage 25, 26 sont vides, c'est-à-dire qu'ils mémorisent des valeurs nulles. Lorsque le signal d'entrée test_in passe à 1, la valeur de la variable d'attente change et la machine d'états passe à un état 0.

Dans l'état d'attente, c'est le signal d'entrée test_in qui joue le rôle de signal d'horloge. Lorsque la machine d'états passe à l'état 0, elle affecte la valeur 1 à un signal de commande d'horloge test_valid, ce qui a pour effet de rendre un signal clk reçu à un plot d'horloge accessible. Ainsi, le signal clk reçu au plot d'horloge joue à présent le rôle de signal d'horloge. La machine d'états passe alors d'un état à l'autre aux fronts montant du signal clk reçu au plot d'horloge, comme illustré sur la figure 6. On passe donc d'un protocole où le rôle de signal d'horloge est joué par le signal test_in à un protocole où le rôle de signal d'horloge est joué par le signal clk reçu au plot d'horloge.

Alternativement, une horloge interne peut jouer le rôle d'horloge dans l'état d'attente. A l'état 0, une éventuelle PLL est coupée afin de se baser sur le signal d'horloge externe clk.

Dés lors que la machine d'états passe à l'état 0, elle utilise un protocole de programmation de mode permettant de programmer le registre TMC. Dans cet exemple, ce protocole impose à la machine d'états de passer de l'état 0 à l'état 1 lorsque le signal test_in repasse à zéro, plus précisément lors du prochain front montant du signal d'horloge clk. Une première variable de décalage tcr_shift se voit alors affecter une valeur 1. Le registre TMC est alors programmé bit à bit à partir des valeurs du signal test_in. La machine d'état détermine donc quelles valeurs du signal test_in servent à remplir le registre de commande TMC. Un compteur non représenté permet de faire passer à 1 un bit reg_end lorsque le chargement du registre TMC est terminé. La machine d'états passe alors de l'état 1 vers l'état 2.

Quand la machine d'état est dans l'état 2, la programmation du registre de commande TMC est terminée. Le registre 25 est alors remis a 0 a l'exception de son premier bit qui est mis a 1. En outre, un registre de sauvegarde non représenté sur la figure 4 est remis à jour en recopiant au moins certaines valeurs mémorisées dans le registre de commande TMC.

Si le signal test_in passe alors à 1 ou reste à 1, la machine d'états est entraînée vers une étape de test 51.

Le test 51 porte sur la valeur de l'un des paramètres de commande du mode de fonctionnement programmés dans le registre TMC, à savoir un paramètre de test de scan scan_mode.

Si ce paramètre a une valeur nulle, la machine d'états s'abstient de se placer en mode de test de scan. Il est procédé à d'autres étapes de test quant aux valeurs d'autres paramètres de commande du mode de fonctionnement mémorisés dans le registre de commande, par exemple un paramètre de test de BIST ou un paramètre de test de parties analogiques du circuit fabriqué. Si l'un de ces derniers paramètres a une valeur non nulle, alors la machine d'états sélectionne un protocole de fonctionnement correspondant au paramètre ayant une valeur non nulle, par exemple un protocole de test de BIST ou un protocole de test de parties analogiques. La machine d'états se place dans un mode de fonctionnement correspondant au paramètre ayant une valeur non nulle, et fonctionne alors selon les spécifications du protocole de fonctionnement sélectionné. La machine d'états peut par exemple procéder à un test de BIST selon les spécifications du protocole de test de BIST, ou bien à un test des parties analogiques selon les spécifications du protocole de test des parties analogiques.

Ces autres étapes de test quant aux valeurs des autres paramètres de commande du mode de fonctionnement, ainsi que les opérations conséquentes, par exemple les opérations d'un test de BIST, sont représentées par le rectangle orienté verticalement 53.

La machine d'état attend ensuite un passage à 0 du signal d'entrée test_in pour passer de l'état 0 à l'état 1. Le registre de commande TMC peut ainsi être reprogrammé, selon les spécifications du protocole de programmation de mode.

Si le paramètre scan_mode a une valeur non nulle, la machine d'états adopte le protocole de test de scan, c'est-à-dire que la machine d'états passe à l'état 3. Une deuxième variable de décalage scan_shift se voit affecter une valeur 1. La machine d'états passe ensuite dans un état 4 similaire, à des fins de synchronisation.

Lorsque la variable scan_shift a une valeur non nulle, le premier registre à décalage 25 de la figure 4 est programmé, toujours à partir des valeurs du signal test_in. La machine d'états permet ainsi de programmer le registre TMC et le premier registre à décalage à partir d'un seul signal test_in.

Lorsque le premier registre à décalage est plein, le 1 initialement chargé atteint le dernier bit scan_end. La machine d'états passe alors de l'état 4 vers l'état 5.

Lorsque la machine d'états se trouve à l'état 5, le premier registre à décalage est a priori programmé. Le registre à décalage comprend huit premiers bits correspondant au registre d'entrée et cinq bits suivant ces huit bits, ces cinq bits correspondant au registre de contrôle. A l'état 5, les valeurs des huit premiers bits sont recopiées vers les moyens de décompression 10 sur la figure 4. De plus, si un bit clk_enable du registre de contrôle est à 1, une variable chip_clk_en se voit affecter la valeur 1, autorisant ainsi un cycle d'horloge de la partie testée 11.

Une étape de test 54 quant à la valeur d'un bit de répétition repeat parmi les cinq bits du registre de contrôle est effectuée.

Si cette valeur est non nulle, la machine d'états retourne à l'état 3 en vue d'une nouvelle programmation du premier registre.

Dans le cas contraire, la machine d'état passe à l'état 6, durant lequel un second cycle d'horloge est appliqué à la partie testée. Ce second cycle d'horloge peut permettre de vérifier que l'une des bascules D de la partie testée commute suffisamment rapidement. La machine d'états retourne ensuite vers l'état 3 en vue d'une nouvelle programmation du premier registre.

Afin de pouvoir sortir d'une boucle de test de scan regroupant les états 3, 4, 5 et éventuellement 6, une étape de test 52 quant à la valeur du signal test_in est effectuée. Si le signal test_in a une valeur non nulle, la machine d'états retourne à l'état 0. Dans le cas contraire, l'étape de test 54 quant à la valeur du bit de répétition repeat est alors effectuée.

Il existe une connexion directe non représentée entre un des bits du registre de contrôle, à savoir un bit d'autorisation scan_en, et le coeur 11. Le bit scan_en a une valeur non nulle durant un certain nombre de boucles de test de scan, durant lesquelles chaque chaîne de scan est chargée avec des valeurs des bits d'entrée. Pour des chaînes de scan de 1500 bascules, 1500 boucles de test de scan sont nécessaires pour parvenir au chargement. Lors de l'exécution de la boucle suivante, le bit scan_en prend une valeur nulle, de sorte que chaque bascule de chaque chaîne de scan capture une valeur de sortie secondaire fonction de la partie combinatoire correspondant à cette chaîne. Les chaînes de scan sont ensuite purgées en exécutant encore 1500 boucles avec le bit scan_en non nul. Les valeurs des sorties secondaires sont lues aux sorties du coeur. Cette nouvelle série de 1500 boucles permet également de charger les chaînes de scan avec des valeurs d'un nouveau vecteur de test de scan.

La figure 7 montre un exemple de registre de test de scan 25 comprenant un registre d'entrée 71, un registre de contrôle 78, ainsi que le dernier bit scan_end 79.

Le registre d'entrée 71 permet de mémoriser les valeurs des bits à envoyer vers les moyens de décompression.

Le registre de contrôle 78 comprend le bit de répétition repeat 72, un bit de contrôle de la compression moxies_mode 73, le bit d'autorisation scan_en 74, un bit de remise à zéro du test de scan scan_reset 75, et un bit d'autorisation d'horloge clk_enable 76.

La valeur du bit moxies_mode 73 permet de déterminer le mode de fonctionnement des moyens de décompression et des moyens de compression.

Lorsque le bit scan_reset 75 est à 1, la partie à tester est remise à zéro.

Le bit clk_enable 76 permet de valider ou non l'horloge de la partie testée 11.

### Variantes

Le dispositif de commande peut ne pas comprendre de registre à décalage. En outre, l'invention n'est bien entendu pas limitée par la présence d'un dispositif de commande pour imposer le mode de fonctionnement. La machine d'états peut par exemple passer d'un mode de fonctionnement à l'autre suivant un ordre prédéfini.

Le dispositif de commande peut ne pas faire partie du groupe de dispositifs et peut ne pas être programmé par la machine d'états.

L'invention n'est pas non plus limitée par les exemples de protocoles décrits.

Chaque protocole, par exemple le protocole de test de scan, peut permettre de transférer des données vers un ou plusieurs dispositifs, par exemple un ou plusieurs dispositifs de test de scan.

Outre le ou les dispositifs de test de scan, le groupe de dispositifs peut comprendre un ou des dispositifs permettant d'effectuer d'autres tests. Le groupe de dispositifs peut également comprendre un ou des dispositifs permettant d'effectuer d'autres fonctions que des fonctions de test.

Le dispositif d'entrée de test peut ne pas comprendre de registre à décalage, en particulier lorsque aucune décompression n'est effectuée. Par exemple, la machine d'état peut être relié à au moins autant de plots qu'il y a de chaînes, chaque chaîne étant ainsi alimentée par un plot correspondant.

Le dispositif de contrôle peut ne pas comprendre de registre à contrôle.

La machine d'états peut être reliée à une machine d'états supplémentaire, la machine d'états supplémentaire permettant de programmer un ou des dispositifs supplémentaires.

## Revendications

1. Circuit électronique comprenant
- un groupe de dispositifs, ledit groupe de dispositifs comprenant un dispositif de test de scan permettant de tester au moins une partie du circuit électronique,
- une machine d'états permettant de transférer des données d'entrée de test depuis un plot d'entrée dédié à ladite machine d'états vers les dispositifs du groupe de dispositifs, ladite machine d'états étant adaptée pour supporter une pluralité de protocoles de transfert de données, le choix du protocole à utiliser étant effectué en fonction au moins d'un signal reçu sur ledit plot d'entrée.

2. Circuit électronique selon la revendication 1, dans lequel la pluralité de protocoles que la machine d'états est adaptée pour supporter comprend au moins un protocole dans lequel le signal reçu à un plot d'horloge joue le rôle de signal d'horloge de la machine d'états, et au moins un protocole dans lequel le rôle de signal d'horloge est assuré par un autre signal.

3. Circuit électronique selon l'une des revendications précédentes, dans lequel
- la machine d'états est adaptée pour être placée sélectivement dans l'un parmi une pluralité de modes de fonctionnement, ladite pluralité comprenant un mode de test de scan, et
- la pluralité de protocoles que la machine d'états est adaptée pour supporter comprend au moins deux protocoles de fonctionnement distincts correspondant chacun à l'un respectif des modes de fonctionnement de la pluralité de modes de fonctionnement.

4. Circuit électronique selon la revendication 3, dans lequel
le groupe de dispositifs comprend un dispositif de commande pour imposer le mode de fonctionnement dans lequel la machine d'états doit être placée.

5. Circuit électronique selon la revendication précédente, dans lequel
le dispositif de commande comprend un registre de commande (TCR, TMC) destiné à mémoriser des paramètres de commande du mode de fonctionnement.

6. Circuit électronique selon l'une des revendications 3, 4 ou 5, dans lequel
la pluralité de protocoles que la machine d'états est susceptible d'utiliser comprend un protocole de programmation de mode permettant de programmer le dispositif de commande.

7. Circuit électronique selon l'une des revendications précédentes, dans lequel
le groupe de dispositifs comprend un dispositif d'entrée de test de scan pour envoyer vers la partie du circuit électronique à tester les données d'entrée de test (Scan_in).

8. Circuit électronique selon la revendication 7, dans lequel
le dispositif d'entrée de test comprend un registre d'entrée pour recevoir les données d'entrée de test (Scan_in) à envoyer vers la partie du circuit électronique à tester.

9. Circuit électronique selon l'une des revendications 7 ou 8, dans lequel
le groupe de dispositifs comprend des moyens de décompression recevant les données d'entrée de test, et des moyens de compression en sortie de la partie testée.

10. Circuit électronique selon l'une des revendications précédentes, dans lequel
le groupe de dispositifs comprend un dispositif de contrôle pour contrôler le déroulement du test.

11. Circuit électronique selon la revendication 10, dans lequel
le dispositif de contrôle comprend un registre de contrôle destiné à mémoriser des paramètres de contrôle du déroulement du test (Scan_en, repeat,...).

12. Circuit électronique selon la revendication 11 lorsqu'elle dépend de la revendication 8, dans lequel
le registre d'entrée et le registre de contrôle font partie d'un même registre à décalage.

13. Appareil électronique comprenant un circuit électronique selon l'une des revendications précédentes.

14. Procédé destiné à être mis en oeuvre par une machine d'états d'un circuit électronique, comprenant les étapes consistant à
- sélectionner un protocole de transfert de données parmi une pluralité de protocoles de transfert de données, la sélection étant effectuée en fonction au moins du signal reçu à un plot d'entrée dédié à la machine d'états, et
- transférer selon les spécifications du protocole sélectionné des données depuis le plot d'entrée vers un dispositif d'un groupe de dispositifs, le choix dudit dispositif étant également effectué en fonction au moins du signal reçu sur ledit plot d'entrée, ledit groupe de dispositifs comprenant un dispositif de test de scan.

## Claims

1. Electronic circuit comprising
- a group of devices, said group of devices comprising a scan test device making it possible to test at least one part of the electronic circuit,
- a state machine making it possible to transfer test input data from an input stud dedicated to said state machine to the devices of the group of devices, the said state machine being suitable for supporting a plurality of data transfer protocols, the choice of the protocol to be used being made as a function of at least one signal received on said input stud.

2. Electronic circuit according to Claim 1, wherein
the plurality of protocols that the state machine is suitable for supporting comprises at least one protocol in which the signal received at a clock stud has the role of clock signal of the state machine, and at least one protocol in which the role of clock signal is ensured by another signal.

3. Electronic circuit according to one of the preceding claims, wherein
- the state machine is suitable for being placed selectively in one from among a plurality of operating modes, said plurality comprising a scan test mode, and
- the plurality of protocols that the state machine is suitable for supporting comprises at least two distinct operating protocols each corresponding to a respective one of the operating modes of the plurality of operating modes.

4. Electronic circuit according to Claim 3, wherein
the group of devices comprises a command device for prescribing the operating mode in which the state machine must be placed.

5. Electronic circuit according to the preceding claim, wherein
the command device comprises a command register (TCR, TMC) intended for storing command parameters of the operating mode.

6. Electronic circuit according to one of Claims 3, 4 or 5, wherein
the plurality of protocols that the state machine is capable of using comprises a mode programming protocol making it possible to program the command device.

7. Electronic circuit according to one of the preceding claims, wherein
the group of devices comprises a scan test input device for dispatching the test input data (Scan_in) to the part of the electronic circuit to be tested.

8. Electronic circuit according to Claim 7, wherein
the test input device comprises an input register for receiving the test input data (Scan_in) to be dispatched to the part of the electronic circuit to be tested.

9. Electronic circuit according to one of Claims 7 or 8, wherein
the group of devices comprises decompression means receiving the test input data, and compression means at the output of the tested part.

10. Electronic circuit according to one of the preceding claims, wherein
the group of devices comprises a control device for controlling the conduct of the test.

11. Electronic circuit according to Claim 10, wherein
the control device comprises a control register intended for storing control parameters for the conduct of the test (Scan_en, repeat,...).

12. Electronic circuit according to Claim 11 when it depends on Claim 8, wherein
the input register and the control register form part of one and the same shift register.

13. Electronic apparatus comprising an electronic circuit according to one of the preceding claims.

14. Method intended to be implemented by a state machine of an electronic circuit, comprising the steps consisting in
- selecting a data transfer protocol from among a plurality of data transfer protocols, the selection being carried out as a function of at least the signal received at an input stud dedicated to the state machine, and
- transferring, according to the specifications of the selected protocol, data from the input stud to a device of a group of devices, the choice of said device also being made as a function of at least the signal received on said input stud, said group of devices comprising a scan test device.

## Patentansprüche

1. Elektronische Schaltung mit:
einer Gruppe von Vorrichtungen, wobei die Gruppe von Vorrichtungen eine Scantestvorrichtung aufweist, die es ermöglicht, zumindest einen Teil der elektronischen Schaltung zu testen,
einer Zustandsmaschine, die es ermöglicht, Testeingabedaten von einem Eingabekontakt, der auf die Zustandsmaschine zugeschnitten ist, zu den Vorrichtungen der Gruppe von Vorrichtungen zu übertragen, wobei die Zustandsmaschine angepasst ist, um eine Vielzahl von Datenübertragungsprotokollen zu unterstützen, wobei die Wahl des zu verwendenden Protokolls entsprechend zumindest einem über den Eingabekontakt empfangenen Signal ausgeführt wird.

2. Elektronische Schaltung nach Anspruch 1, wobei
die Vielzahl von Protokollen, die von der Zustandsmaschine unterstützt wird, zumindest ein Protokoll, bei dem das an einem Taktkontakt empfangene Signal die Rolle eines Taktsignals der Zustandsmaschine spielt, und zumindest ein Protokoll aufweist, bei dem die Rolle eines Taktsignals durch ein anderes Signal sichergestellt wird.

3. Elektronische Schaltung nach einem der vorstehenden Ansprüche, wobei
die Zustandsmaschine angepasst ist, um selektiv unter einer Vielzahl von Betriebsmodi angebracht zu werden, wobei die Vielzahl einen Scantestmodus aufweist, und
die Vielzahl von Protokollen, die von der Zustandsmaschine unterstützt werden, zumindest zwei verschiedene Betriebsprotokolle aufweist, wobei jedes einem entsprechenden Betriebsmodus der Vielzahl von Betriebsmodi entspricht.

4. Elektronische Schaltung nach Anspruch 3, wobei
die Gruppe von Vorrichtungen eine Befehlsvorrichtung aufweist, um den Betriebsmodus, bei dem die Zustandsmaschine angeordnet sein muss, festzusetzen.

5. Elektronische Schaltung nach einem der vorstehenden Ansprüche, wobei
die Befehlsvorrichtung ein Befehlsregister (TCR, TMC) aufweist, das eingerichtet ist, um Befehlsparameter des Betriebsmodus zu speichern.

6. Elektronische Schaltung nach einem der Ansprüche 3, 4 oder 5, wobei
die Vielzahl von Protokollen, die die Zustandsmaschine imstande ist, zu verwenden, ein Modusprogrammierungsprotokoll aufweist, das es ermöglicht, die Befehlsvorrichtung zu programmieren.

7. Elektronische Schaltung nach einem der vorstehenden Ansprüche, wobei
die Gruppe von Vorrichtungen eine Scantesteingabevorrichtung aufweist, um die Testeingabedaten (Scan_in) zu dem zu testenden Teil der elektronischen Schaltung zu senden.

8. Elektronische Schaltung nach Anspruch 7, wobei
die Testeingabevorrichtung ein Eingaberegister aufweist, um die zu dem zu testenden Teil der elektronischen Schaltung zu sendenden Testeingabedaten (Scan__in) zu empfangen.

9. Elektronische Schaltung nach einem der Ansprüche 7 oder 8, wobei
die Gruppe von Vorrichtungen Entkomprimierungseinrichtungen, die die Testeingabedaten empfangen, und Komprimierungseinrichtungen am Ausgang des getesteten Teils aufweist.

10. Elektronische Schaltung nach einem der vorstehenden Ansprüche, wobei
die Gruppe von Vorrichtungen eine Steuervorrichtung aufweist, um den Testablauf zu steuern.

11. Elektronische Schaltung nach Anspruch 10, wobei
die Steuervorrichtung ein Steuerregister aufweist, das eingerichtet ist, um Steuerparameter des Testablaufs (Scan_en, repeat, ...) zu speichern.

12. Elektronische Schaltung nach Anspruch 11, wenn er von Anspruch 8 abhängt, wobei
das Eingaberegister und das Steuerregister einen Teil eines selben Verschiebungsregisters bilden.

13. Elektronisches Gerät, das eine elektronische Schaltung nach einem der vorstehenden Ansprüche aufweist.

14. Verfahren, das eingerichtet ist, um von einer Zustandsmaschine einer elektronischen Schaltung ausgeführt zu werden, mit den folgenden Schritten:
Auswählen eines Datenübertragungsprotokolls unter einer Vielzahl von Datenübertragungsprotokollen, wobei die Auswahl entsprechend zumindest dem an einem Eingabekontakt, der auf die Zustandsmaschine zugeschnitten ist, empfangenen Signal bewirkt wird,
Übertragen von Daten von dem Eingabekontakt zu einer Vorrichtung einer Gruppe von Vorrichtungen gemäß den Spezifikationen des ausgewählten Protokolls, wobei die Wahl der Vorrichtung gleichermaßen entsprechend zumindest dem über den Eingabekontakt empfangenen Signal bewirkt wird, wobei die Gruppe von Vorrichtungen eine Scantestvorrichtung aufweist.
